# EUROPEAN PATENT SPECIFICATION

(11) **EP 3 667 725 B1**
(45) Date of publication and mention of the grant of the patent: **20.09.2023**
(21) Application number: 18844428.5
(22) Date of filing: 13.04.2018
(51) Int. Cl.: H10K 50/842, H10K 50/844, H10K 59/131, G02F 1/1362, G02F 1/1368

(54) **ARRAY SUBSTRATE AND MANUFACTURING METHOD THEREFOR, DISPLAY PANEL AND MANUFACTURING METHOD THEREFOR**
ARRAYSUBSTRAT UND HERSTELLUNGSVERFAHREN DAFÜR, ANZEIGETAFEL UND HERSTELLUNGSVERFAHREN DAFÜR
SUBSTRAT DE RÉSEAU ET SON PROCÉDÉ DE FABRICATION, PANNEAU D'AFFICHAGE ET SON PROCÉDÉ DE FABRICATION

(30) Priority: 09.08.2017 CN 201710677512
(43) Date of publication of application: 17.06.2020
(73) Proprietor: Kunshan Go-Visionox Opto-Electronics Co., Ltd., KunShan City, Jiangsu 215300 (CN)
(72) Inventor: LIU, Quan, Kunshan Jiangsu 215300 (CN); ZHANG, Lu, Kunshan Jiangsu 215300 (CN); HAN, Zhenzhen, Kunshan Jiangsu 215300 (CN); HU, Siming, Kunshan Jiangsu 215300 (CN); ZHU, Hui, Kunshan Jiangsu 215300 (CN)
(74) Representative: Kraus & Weisert Patentanwälte PartGmbB
(86) International application number: PCT/CN2018/082961
(87) International publication number: WO 2019/029182

(56) References cited:
- CN-A- 104 280 958
- CN-A- 104 769 657
- JP-A- 2007 034 235
- JP-A- 2010 102 237
- US-A1- 2008 067 932
- US-A1- 2016 293 883

## Description

### TECHNICAL FIELD

The present application relates to the field of panel display, in particular to an array substrate, a method for manufacturing the same, a display panel and a method for manufacturing the same.

### BACKGROUND

A display panel has a display area (or active area, AA area) and a non-display area. In the display area, a plurality of pixels are configured to form a pixel array, while in the non-display area, a plurality of metal layers are disposed to form peripheral lines. Each pixel generally includes at least a thin film transistor and a pixel electrode connected to the thin film transistor, and each pixel is surrounded by two adjacent scanning lines and two adjacent data lines. These scanning lines and data lines extend from the display area to the non-display area, and are electrically connected to a driver chip via the peripheral lines of the non-display area, thus realizing the normal work of the display panel. A fan-out line is formed by the convergence of the peripheral lines from one end connecting the scanning line and the data line to the area where the driver chip is located. That is, a plurality of peripheral lines have large spacing at the end near the active area and a small spacing at the end near the driver chip, thus forming a fan shape substantially.

US 2008/067932 A1 discloses an organic light emitting display and a method of fabricating the same. One embodiment of the organic light emitting display includes a substrate including a pixel region and a cathode-on-driver (COD) region adjacent to the pixel region, a thin film transistor formed on the pixel region of the substrate, and a planarization film formed on an entire surface of the substrate to cover the thin film transistor. The organic light emitting display also includes an organic light emitting diode including a first pixel electrode formed on the planarization film and connected to the thin film transistor, an organic light emitting layer formed on the first pixel electrode, and a second pixel electrode formed on an entire surface of the substrate over the organic light emitting layer. The organic light emitting display further includes a pixel definition layer which is provided between the planarization film and the second pixel electrode. The pixel definition layer has an opening where the organic light emitting layer is located. Openings are formed through the planarization film and the pixel definition layer to provide a recess for separating the pixel region and the COD region from each other. The organic light emitting display further includes a conductive layer partially filling the recess for reducing the depth of the recess.

After studies, the inventor finds that fan-out lines, especially metal leads, are prone to metal cracks, which eventually lead to bright traces in the display panel, which has a great impact on the yield of the display panel. Therefore, how to reduce or even avoid the occurrence of metal cracks is a technical problem which needs to be urgently solved by those skilled in the art.

### SUMMARY OF THE INVENTION

The present application is directed to an array substrate and a manufacturing method thereof, and a display panel and a manufacturing method thereof, the occurrence rate of a metal crack can be lowered, an electrostatic damage of a detection circuit in a bonding area can be avoided, and image quality of the display panel is improved.

In order to achieve the above purpose, the present application provides an array substrate and a method according to the independent claims. Advantageous embodiments are described in the dependent claims.

It is disclosed an array substrate, including:
a substrate;
a detection circuit and at least one metal layer deviating from the detection circuit, both located on the substrate; and
a protective layer covering the metal layer and exposing the detection circuit; and as further defined in claim 1.

Optionally, a material of the protective layer is one or a combination of silicon nitride, silicon oxide and silicon oxynitride.

The array substrate further includes a plurality of input and output terminals formed on the substrate, and the protective layer exposes the plurality of input and output terminals.

Optionally, the detection circuit and the plurality of input and output terminals form a bonding area, and an area exposed by the protective layer is equal to the bonding area or greater than the bonding area.

Optionally, the substrate includes a packaging area, and the protective layer only covers the metal layer in the packaging area.

Correspondingly, the present application further provides a method for manufacturing an array substrate, including:
providing a substrate, and forming a detection circuit and at least one metal layer deviating from the detection circuit both on the substrate; and
forming a protective layer, enabling the protective layer to cover the metal layer and expose the detection circuit; and as further defined in claim 4.

Optionally, the method for manufacturing an array substrate further includes: arranging a plurality of input and output terminals on the substrate, the protective layer exposing the plurality of input and output terminals.

Optionally, the substrate includes a packaging area; and the protective layer only covers the metal layer in the packaging area.

Optionally, the substrate includes a display area and a non-display area, and the packaging area, the detection circuit and the plurality of input and output terminals are all located in the non-display area; the metal layer is formed both in the non-display area and the display area; and while forming the metal layer, the detection circuit is formed in the non-display area and a plurality of thin film transistors are formed in the display area; the protective layer is formed both in the non-display area and the display area; and the forming a protective layer further comprises: removing a portion of the protective layer corresponding to a position of a contact hole in the display area to expose the contact hole while enabling the protective layer to expose the detection circuit.

Correspondingly, the present application further provides a display panel, including an array substrate as defined in claim 1 and a glass cover plate, the display panel includes a display area and a non-display area, the non-display area further includes a packaging area and a bonding area, and the array substrate includes:
a substrate;
a detection circuit and at least one metal layer deviating from the detection circuit, both located on the substrate; and
a protective layer, the protective layer covering the metal layer and exposing the detection circuit;
a packaging area of the array substrate or the glass cover plate is coated with a frit to package the array substrate and the glass cover plate; and
the display panel further includes a driver chip bonded in the bonding area.

Optionally, a material of the protective layer is one or a combination of silicon nitride, silicon oxide and silicon oxynitride.

The array substrate further includes a plurality of input and output terminals formed on the substrate, and the protective layer exposes the plurality of input and output terminals.

Optionally, the detection circuit and the plurality of input and output terminals are both located in the bonding area, and an area exposed by the protective layer is equal to the bonding area or greater than the bonding area.

Optionally, the protective layer only covers the metal layer in the packaging area.

Correspondingly, the present application further provides a method for manufacturing a display panel, the display panel includes a display area and a non-display area, the non-display area further includes a packaging area and a bonding area, and the method includes:
manufacturing an array substrate by using the method for manufacturing an array substrate as described above, and providing a glass cover plate;
coating a packaging area of the array substrate or the glass cover plate with a frit, and packaging the array substrate and the glass cover plate;
performing laser irradiation on the frit; and
bonding a driver chip in the bonding area;
and as further defined in claim 4.

Compared with the prior art, in the array substrate and the manufacturing method thereof, and the display panel and the manufacturing method thereof provided by the present application, after at least one metal layer is formed on the substrate, the protective layer is formed on the metal layer, the protective layer can protect the metal layer, damage caused to the metal layer when laser irradiation is subsequently performed on the frit in the display panel is avoided, and therefore the occurrence rate of a metal crack is lowered, and the yield of the display panel is improved easily. Besides, due to the technical scheme of the present application, the protective layer exposes the detection circuit, electrostatic damage, caused by covering by the protective layer, of the detection circuit can be avoided, and the yield of the display panel is further improved.

### BRIEF DESCRIPTION OF THE DRAWINGS

FIG. 1 is a partial sectional view of a non-display area, containing a packaging area, of a display panel;
FIG. 2 is a flow view of a manufacturing method of an array substrate provided by an embodiment of the present application;
FIG 3 is a partial sectional view of a non-display area, containing a packaging area, of the array substrate provided by the embodiment of the present application;
FIG 4 is a partial top view of a non-display area, containing a bonding area, of the array substrate provided by the embodiment of the present application;
FIG 5 is a position relationship schematic view of a packaging area and a bonding area in a display panel provided by an embodiment of the present application; and
FIG 6 is a partial sectional view of a non-display area, containing a packaging area, of the display panel provided by the embodiment of the present application.

### DETAILED DESCRIPTION

A display panel, such as an organic light-emitting diode (OLED) display panel commonly includes an array substrate and a glass cover plate which are arranged oppositely. The display panel includes a display area and a non-display area, and a packaging area is arranged in the non-display area, and used for coating with frit to package the array substrate and the glass cover plate.

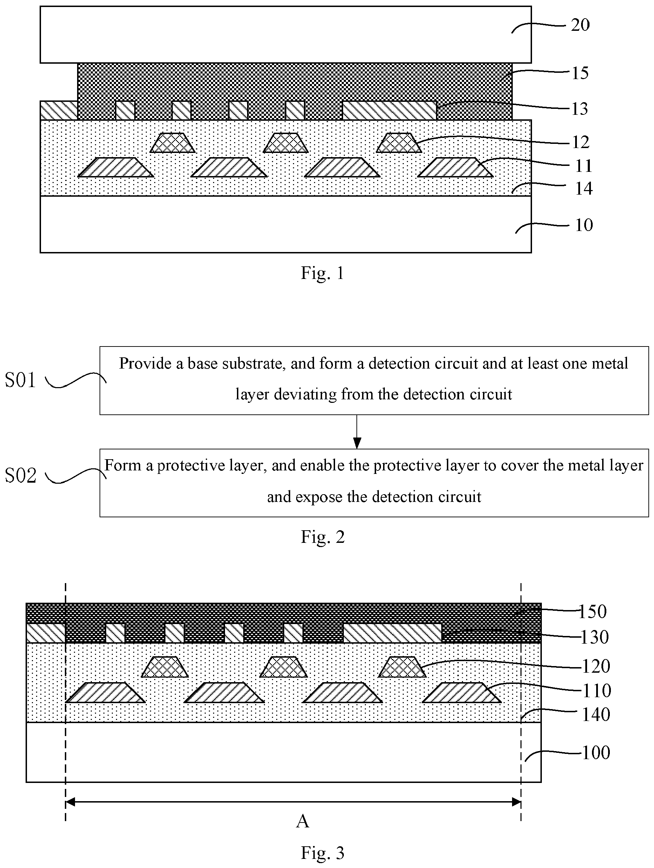

As shown in FIG. 1, it is a partial structural schematic view of a non-display area of a display panel. As shown in FIG. 1, the display panel includes a substrate 10 and a glass cover plate 20 which are oppositely arranged. In the non-display area, a plurality of metal layers are formed on the substrate 10, only three metal layers are shown in the FIG 1, and are respectively a bottom metal layer 11, an intermediate metal layer 12 and a top metal layer 13. The three metal layers are isolated from one another by dielectric layers 14, the top metal layer 13 in a packaging area is directly coated with frit 15, and then the substrate 10 and the glass cover plate 20 are packaged to form the display panel. Metal layers such as the bottom metal layer 11, the intermediate metal layer 12, and the top metal layer 13 formed in the non-display area belong to fan-out wires, and are used for connecting a driver chip to a data line, a scanning line and the like in a display area, and transmit an electric signal provided by the driver chip to the data line or the scanning line.

In order to well package the substrate 10 and the glass cover plate 20, a scheme of one embodiment of the present application is as follows: after at least one metal layer is formed on the substrate, a protective layer is formed on the metal layer. The protective layer can protect the metal layer, damage caused to the metal layer when laser irradiation is subsequently performed on the frit in the display panel may be avoided (for example, it is avoided that a crack occurs on the metal layer in an advancing direction perpendicular to laser), and therefore occurrence of a metal crack is lowered. The applicant further finds that accidentally, the method lowers the bright line badness rate of the display panel, and the reason why a bright line occurs on the display panel is that the damage or the crack of the metal layer can result in that a certain data line or a scanning line in the display area cannot receive a signal or a received signal is not accurate.

In another embodiment of the present application, a substrate is provided, and a detection circuit and at least one metal layer deviating from the detection circuit are formed on the substrate; and a protective layer is formed, and the protective layer covers the metal layer, and exposes the detection circuit. The inventor finds that, after at least one metal layer is formed on the substrate, the protective layer is formed on the metal layer. The protective layer can protect the metal layer, damage caused to the metal layer when laser irradiation is subsequently performed on the frit in the display panel is avoided, and therefore the occurrence rate of a metal crack is lowered, and the yield of the display panel is improved easily. Besides, after the protective layer is formed, the protective layer exposes the detection circuit, electrostatic badness, caused by covering by the protective layer, of the detection circuit can be avoided, especially, accumulated electrostatic charges in the detection circuit (CT circuit) may be eliminated, and therefore the yield of the display panel is further improved.

For the purpose of making the content of the present application more clear, the content of the present application is further illustrated in conjunction with the drawings of the description.

Secondly, the present application utilizes the schematic view to perform detailed expression, and when the embodiments of the present application are illustrated in detail, in order to facilitate illustration, the schematic view is not partially amplified according to the common proportion, which should not serve as limitation of the present application.

Referring to FIG. 2, it is a flow chart of a manufacturing method of an array substrate provided by an embodiment of the present application, and as shown in FIG. 2, the present application provides a manufacturing method of an array substrate, including following steps:
Step S01: Provide a substrate, and form a detection circuit and at least one metal layer deviating from the detection circuit on the substrate.
Step S02: Form a protective layer, and enable the protective layer to cover the metal layer and expose the detection circuit.

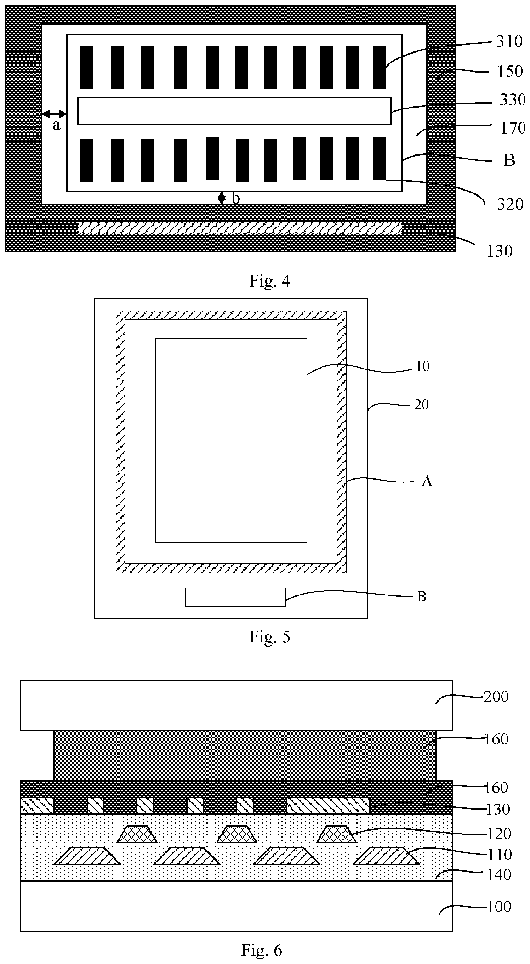

FIG 3 is a partial sectional view of a non-display area, containing a packaging area, of an array substrate provided by an embodiment of the present application, FIG. 4 is a partial top view of a non-display area, containing a bonding area, of the array substrate provided by the embodiment of the present application, and referring to FIG. 2, in combination of FIG 3 and FIG 4, the manufacturing method of the array substrate provided by the present application is illustrated in detail.

In step S01, a substrate 100 is provided. In the present embodiment, the substrate 100 includes a display area and a non-display area, and the non-display area encircles the display area. A packaging area and a driver chip bonding area are arranged in the non-display area. Of course, in other embodiments, the non-display area and the display area may also be located on different surfaces of the substrate. For example, the non-display area is located on a back side of the substrate, an area of the display area is not occupied, and therefore the resolution ratio is increased, so that a narrow frame or no frame is achieved, which is not limited by the present application.

The substrate 100 may be made of a transparent material, such as glass, quartz, silicon wafers, polycarbonate, polymethyl methacrylate or metal foil or the like. The substrate 100 may be a rigid substrate, and may also be a flexible substrate. Selection and pretreatment of the substrate 100 are familiar to those skilled in the art, and thus is not illustrated in detail. The display area is subsequently used for forming a scanning line, a data line, a transistor switch or a pixel electrode or the like on the substrate 100. The non-display area is subsequently used for forming a fan-out wire on the substrate 100, and used for connecting the scanning line, the data line and the like of the display area to a driver chip.

As shown in FIG 3, the non-display area includes a packaging area A, the packaging area A is coated with frit after the array substrate is formed, and the frit is used for packaging the array substrate and the glass cover plate to form a display panel. The packaging area is similarly provided with a fan-out wire. In one embodiment, the packaging area A is annular, and encircles the display area. FIG 3 only shows the sectional view of part of the non-display area containing the packaging area A.

As shown in FIG 4, the non-display area further includes a driver chip bonding area B, and after the display panel is formed, the driver chip is bonded in the driver chip bonding area B. One end of the fan-out wire in the non-display area is connected to the scanning line, the data line and the like of the display area, the other end extends to the binding area B. That is, the fan-out wire is provided with an input terminal 310 and an output terminal 320 in the bonding area B to serve as input and output of the driver chip. A detection circuit 330 is further arranged between the input terminal 310 and the output terminal 320, and the detection circuit 330 contains a plurality of transistors connected with one another, is connected to the display area via the fan-out wire, and is used for detecting a circuit of the array substrate before bonding the driver chip or forming the display panel. It should be noted that a size of the bonding area B is completely consistent with that of an outer frame of the driver chip. FIG. 4 only shows the top view of part of the non-display area containing the bonding area B.

Referring to a position relationship schematic view of the packaging area A and the bonding area B in FIG. 5. As shown in FIG 5, a finally formed display panel includes a display area 10 and a non-display area 20. The non-display area 20 encircles the display area 10, the packaging area A and the bonding area B are both located in the non-display area 20. The packaging area A encircles the display area 10, and is used for packaging an array substrate and a glass cover plate together, and the bonding area B is located on an edge of one side of the non-display area 20, and used for bonding a driver chip.

Then, referring to FIG 3 and FIG 4, the detection circuit 330, a plurality of input terminals 310 and output terminals 320 are formed in the bonding area B of the substrate 100. The input terminals 310 and the output terminals 320 are both regularly arranged. Preferably, the plurality of input terminals 310 are arranged into a column, the plurality of output terminals 320 are arranged into a column, and the two columns are both parallel with one side edge of the array substrate. The detection circuit 330 is located between the input terminal 310 and the output terminal 320.

While the detection circuit 330, the input terminal 310 and the output terminal 320 are formed in the bonding area B of the substrate 100, at least one metal layer deviating from the detection circuit 330 is formed in the non-display area of the substrate 100, and here, "deviating" means no overlapping in a direction perpendicular to the substrate 100. In the present embodiment, preferably, three metal layers are formed in the non-display area of the substrate 100, and respectively are a bottom metal layer 110, an intermediate metal layer 120 and a top metal layer 130. In other embodiments, two metal layers, four metal layers or more metal layers may also be formed, and it needs to be determined according to an actual requirement of the array substrate, which is not limited in the present application. The bottom metal layer 110, the intermediate metal layer 120 and the top metal layer 130 are isolated by a dielectric layer 140. A position relationship of the metal layers, the input terminal 310, the output terminal 320 and the detection circuit 330 is as shown in FIG. 4, the input terminal 310 is close to an edge of the substrate, the output terminal 320 is close to a center area of the substrate, the metal layer may be arranged in the non-display area on a side, away from the input terminal 310, of the output terminal 320, and as shown in FIG. 4, the top metal layer 130 is schematically marked out. Of course, the position relationship may also refer to FIG. 5, the metal layer may be arranged in the non-display area 20 from the bonding area B to the display area 10, and of course, the metal layer may also be arranged in the non-display area 20 on other three sides.

Preferably, the input terminal 310 and the output terminal 320 each include two metal layers connected via a contact hole. The input terminal 310 and the output terminal 320 are formed while the bottom metal layer 110, the intermediate metal layer 120 and the top metal layer 130 are formed.

For example, a first metal layer is formed in the bonding area while the bottom metal layer 110 is formed, then a dielectric layer is formed in the bonding area while the dielectric layer is formed on the bottom metal layer 110, after that, etching (the etching may be synchronous with certain time etching in the display area) is performed on the dielectric layer to form a through hole, then filling is performed on the through hole to form a second metal layer while the intermediate metal layer 120 is formed, and the first metal layer and the second metal layer form the input terminal 310 or the output terminal 320.

Preferably, in the process of forming a thin film transistor in the display area, the detection circuit is formed in the bonding area. Preferably, the detection circuit includes a plurality of mutually connected thin film transistors, the quantity of the transistors and a connection relationship between the transistors are determined according to an actual requirement, a specific structure of the detection circuit is not described in detail in the present embodiment, and the detection circuit is not specifically limited by the present application.

Preferably, a plurality of metal film layers are also formed in the display area of the substrate 100 while the input terminal 310 and the output terminal 320 are formed in the non-display area of the substrate 100, for example, a data line, a scanning line or a pixel electrode or the like is formed. That is, a plurality of metal layers are formed in the non-display area and an input/output terminal is formed in the bonding area of the non-display area while the data line, the scanning line, the pixel electrode or other metal film layers are formed in the display area. Thus, a material of the plurality of metal layers and the input/output terminal depends on a material of the data line, the scanning line, the pixel electrode or other metal film layers formed both in the display area, and materials of the plurality of metal layers may be different from one another, and may also be totally the same. The material of the plurality of metal layers contains, but is not limited, to copper, aluminum, nickel, magnesium, chromium, molybdenum, tungsten, alloys thereof and the like. Of course, the plurality of metal layers may also be formed separately in the non-display area of the substrate 100.

The plurality of metal layers is isolated by the dielectric layers 140, the dielectric layers 140 between different metal layers are formed in different steps, but all configured for isolating the metal layers, thus, no distinguishing is performed in FIG. 3. It may be understood that a forming step of the dielectric layers 140 is also synchronous with forming of an insulating layer in the display area, for example, any layer in the dielectric layers 140 is formed in the process of forming a gate insulating layer, an interlayer insulating layer and the like of the transistor, and then a material of the dielectric layer is the same as a material of the gate insulating layer and the interlayer insulating layer formed at the same time. The material of the dielectric layer 140 contains, but is not limited to, oxide or nitride, and of course, materials of the dielectric layers between different metal layers may be different. It may be understood that the dielectric layers 140 may also be independently formed between the plurality of metal layers, that is, the plurality of metal layers and the dielectric layers formed in the non-display area may be formed both with the metal layer or the insulating layer in the display area, and may also be independently formed.

A method for forming the plurality of metal layers and the dielectric layers in the non-display area of the substrate 100 is introduced simply below, and includes following steps.

Firstly, a first dielectric layer is formed on the substrate 100, and preferably, a chemical vapor deposition method may be adopted for forming, such as, high density plasma chemical vapor deposition (HDPCVD), low pressure chemical vapor deposition (LPCVD) or ultra high vacuum chemical vapor deposition (UHVCVD) or the like. Then, bottom metal is formed on the first dielectric layer, and preferably, forming is achieved by adopting a sputtering method. Then patterning is performed on the bottom layer metal, the patterning process includes, for example, spin coating of photoresist, exposing, developing and an etching processes, and the bottom metal layer 110 is formed. Then the above step is repeated, a second dielectric layer is formed on the bottom metal layer 110, the second dielectric layer covers the bottom metal layer 110, then intermediate metal is formed on the second dielectric layer, and etching is performed to form the intermediate metal layer 120. Then a third dielectric layer is formed on the intermediate metal layer 120, the third dielectric layer covers the intermediate metal layer 120. Finally, top metal is formed on the third dielectric layer, and after etching, the top metal layer 130 is formed. The first dielectric layer, the second dielectric layer and the third dielectric layer form the dielectric layer 140 as shown in FIG. 3. It may be understood that the quantity of the metal layers is not limited to three introduced above, only two metal layers may also be included, or four or more metal layers may also be included, and correspondingly, the quantity of the dielectric layers may also adaptively change according to the quantity of the metal layers.

In step S02, referring to FIG. 3, a protective layer 150 is formed in the non-display area, and the protective layer 150 covers the top metal layer 130 in the plurality of metal layers in the non-display area, the detection circuit 330, the input terminal 310 and the output terminal 320. The protective layer 150 may be of a single-layer structure, and may also be of a laminated structure. A material of the protective layer 150 contains, but is not limited to, silicon nitride, silicon oxide or silicon oxynitride, of course, the material of the protective layer 150 may also be other materials known by those skilled in the art, as long as the metal layer can be protected against damage of laser irradiation used during subsequent packaging. Due to the fact that the silicon nitride, silicon oxide or silicon oxynitride is a conventional material in the art, silicon nitride, silicon oxide or silicon oxynitride may serve as a preferable material of the present embodiment. Preferably, a thickness of the protective layer 150 is 2000 Å to 4000 Å, and most preferably, a thickness of the protective layer 150 is 3000 Å. The protective layer 150 of the thickness can protect the metal layer against damage of laser irradiation, and cannot affect a thickness of the finally formed display panel, either.

In the present embodiment, the protective layer 150 is formed by adopting the chemical vapor deposition method, according to conditions of the forming a protective layer 150, preferably, cavity temperature is 350°C to 400°C, cavity pressure is 900 mtorr to 1100 mtorr, film forming time is 350 s to 450 s, and optimally, the cavity temperature is 385°C, the cavity pressure is 1000 mtorr, and the film forming time is 400 s.

Preferably, a protective layer is also formed in the display area while the protective layer 150 is formed in the non-display area. That is, the protective layer is formed both on the whole substrate 100, etching is performed on the protective layer at a position, provided with a contact hole, in the display area, the contact hole is exposed, and it is avoided that the protective layer affects connection of the display area. A film layer before the protective layer is formed in the display area is not limited, for example, the top metal layer is formed in the non-display area while the data line is formed in the display area, later if the protective layer is directly formed, in the display area, the protective layer is formed on the data line. If the protective layer is formed after other film layers (such as the scanning line) need to be formed on the data line in the display area, in the display area, the protective layer is formed on the scanning line.

The protective layer 150 is formed on the top metal layer 130. The protective layer 150 is used for protecting the metal layer, influences of laser to the metal layer when laser irradiation is subsequently performed are avoided, and therefore a metal crack is avoided, the occurrence rate of the metal crack is lowered, and finally, the yield of the display panel is improved. However, due to the fact that the protective layer 150 is also formed in the bonding area B, the detection circuit 330 in the bonding area B is covered by the protective layer 150, elimination of surface charges is not facilitated, occurrence of electrostatic badness on the detection circuit is caused easily, and thus, the step S04 needs to continue to be performed.

Then, referring to FIG. 4, patterning is performed on the protective layer 150, an opening hole is formed. The opening hole exposes the detection circuit 330, the input terminal 310 and the output terminal 320 in the bonding area B.

Specifically, a photoresist layer is formed on the protective layer 150, exposing and developing are performed on the photoresist layer, a patterned photoresist layer is formed, and the protective layer 150 on the detection circuit 330, the input terminal 310 and the output terminal 320 in the bonding area B is exposed; then, with the patterned photoresist layer as a mask, etching is performed on the protective layer 150, preferably, etching is performed on the protective layer 150 by adopting plasma dry etching, an exposed protective layer 150 is removed, and the detection circuit 330, the input terminal 310 and the output terminal 320 in the bonding area B are exposed.

Preferably, etching gas is mixed gas of C₂HF₅ (pentafluoroethane), H₂ (hydrogen) and Ar (argon). The argon may improve energy of ion bombardment, reaction of pentafluoroethane and the protective layer is promoted through ion bombardment, and the reaction rate may be increased. The etching gas may also be mixed gas of CF₄ (carbon tetrafluoride) and O₂ (oxygen), or other etching gas known by those skilled in the art, and of course, etching may also be performed on the protective layer 150 by adopting other etching methods known by those skilled in the art, which is not limited by the present application.

Preferably, performing patterning on the protective layer 150 further includes exposing a remaining bonding area, except the detection circuit 330, the input terminal 310 and the output terminal 320, that is, by performing patterning on the protective layer 150, a size of the formed opening hole is equal to that of the bonding area. As shown in FIG. 4, patterning is performed on the protective layer 150, the bonding area B may be directly exposed by etching, compared with that only the detection circuit 330, the input terminal 310 and the output terminal 320 in the bonding area B are exposed, the range of etching is widened, and process difficulty may be lowered to a certain degree.

Of course, in order to avoid influences on the display panel when the driver chip is bonded subsequently, when patterning is performed on the protective layer 150, the non-display area distanced from a periphery of the bonding area B within 0-100 µm may also be exposed, such as an opening 170 in FIG. 4, and a size of the opening 170 is greater than that of the bonding area B. That is, when etching is performed on the protective layer 150, the opening 170 is directly formed, compared with that the bonding area B is exposed, the range of etching is further widened, and process difficulty is further lowered. The opening 170 is in a direction parallel with a long edge of the driver chip, a length a is respectively increased compared with two sides of the bonding area B, in a direction parallel to a short edge of the driver chip, a width b is respectively increased for the opening 170 compared with the two sides of the bonding area B, and sizes of the length a and the width b are both within 0 to 100 µm, such as, 20 µm, 40 µm, 60 µm, 80 µm or 100 µm. Of course, the size may also be greater than 100 µm if it is allowed by the size of the non-display area, and the specific size of the opening 170 is determined by a size in an actual display panel and process conditions of etching.

Of course, when patterning is performed on the protective layer 150, etching may also be performed on an area, except the packaging area A, of the non-display area while the protective layer in the bonding area B is removed, only the protective layer 150 (as shown in FIG 3) on the top metal layer 130 in the packaging area A is reserved, in this way, occurrence of a metal crack may be reduced, electrostatic badness caused by the fact that the protective layer is formed on the detection circuit in the bonding area may also be avoided, and therefore the yield of a product is improved easily.

When etching is performed on the protective layer 150, the protective layer in the display area may also be removed at the same time. That is, after the protective layer is formed, it is needed to perform etching on the protective layer at the position, provided with the contact hole, in the display area, and the contact hole is exposed. In addition, in the etching process, the protective layer on the bonding area in the non-display area may be removed in an etching manner, the protective layer in the remaining area, except the packaging area, in the non-display area may also be removed in an etching manner, all the protective layer in the display area may also be etched away, and it is needed to perform selection according to actual conditions.

Specifically, the protective layer 150 is coated with the photoresist layer, exposing is performed on the photoresist layer via a mask. For positive photoresist, the mask may only expose the contact hole in the display area, or the whole display area is exposed, or the bonding area in the non-display area is exposed, or other areas, except the packaging area, in the non-display area are exposed, or all the non-display area except the packaging area and all the display area are exposed, and the mask for using is determined according to a specific condition. Then developing is performed on the photoresist layer after the photoresist layer is subjected to exposing, the patterned photoresist layer is formed. Then etching is performed on the protective layer with the patterned photoresist layer as the mask. Finally, a remaining photoresist layer is stripped away, and a pattern of a needed protective layer is formed.

It needs to be noted that in the process of performing etching on the protective layer with the patterned photoresist layer as the mask, it needs to avoid damage to other film layers below the protective layer, for example, when etching is performed on the protective layer of the remaining area, except the packaging area, of the non-display area, it needs to avoid damage to the top metal layer below the protective layer. Aiming at the problem, an etching selection ratio may be adjusted, a proper etching selection ratio is selected to perform etching on the protective layer, it is guaranteed that a high etching rate is achieved on the protective layer, a low etching rate is achieved on remaining film layers, or no etching is performed on the remaining film layers. For example, preferably the etching selection ratio of the protective layer to the remaining film layers is greater than 5:1.

Besides, in the step of performing etching on the protective layer 150, partial etching may also be performed on the protective layer 150 in the packaging area, so that at least part of a surface, deviating from the top metal layer 130, of the protective layer 150 in the packaging area is a concave surface, a convex surface or a concave-convex surface. That is, at least part of the surface, deviating from the top metal layer 130, of the protective layer 150 is a non-plane surface, a better bonding force is achieved between coated frit and the protective layer 150, that is, the bonding force of the frit and the protective layer is improved via the non-plane surface, and therefore reliability of the finally formed display panel is improved.

Preferably, the concave surface or the convex surface is one or a combination of a cylinder, a cone, a circular truncated cone or a hemisphere. The concave-convex surface is formed by connecting the concave surface and the convex surface in a staggered manner, and may also be formed by arranging the concave surface and the convex surface at intervals in a staggered manner. For example, the concave surface is composed of a plurality of grooves formed on the surface of the protective layer 150, and the grooves may be the same in size and shape, and may also be different in size and shape. For example, the convex surface is composed of a plurality of protrusions formed on the surface of the protective layer 150, and the protrusions may be the same in size and shape, and may also be different in size and shape. The concave-convex surface is composed of the plurality of grooves and the plurality of protrusions formed on the surface of the protective layer 150, and similarly, shapes and sizes of the grooves and the protrusions are not limited.

Finally, a structure as shown in FIG 3 and FIG 4 is formed, after the forming a protective layer 150, and before packaging, completing manufacturing of the remaining film layers in the display area of the substrate 100 is further included, a manufacturing method of the remaining film layers is familiar to those skilled in the art, and thus is not described in detail any more, and finally, manufacturing of the array substrate is completed.

Correspondingly, the present application further provides a manufacturing method of a display panel, including the manufacturing method of the array substrate as mentioned above. Referring to FIG 3, FIG 4 and FIG. 6, the manufacturing method of the display panel includes the following steps.

Manufacturing of an array substrate is completed, and a glass cover plate 200 is provided.

A packaging area of the array substrate or the glass cover plate 200 is coated with frit 160, and the array substrate is packaged with the glass cover plate 200.

Laser irradiation is preformed on the frit; a protective layer 150 can protect a metal layer, it is avoided that the metal layer generates a crack, the occurrence rate of the crack is lowered, and the yield of the display panel is improved.

A driver chip is bonded in a bonding area of the array substrate, due to the fact that a protective layer on a testing circuit 330 is removed, it can be avoided that a detection circuit is damaged by static electricity, the occurrence rate of electrostatic badness is lowered, and the yield of the display panel is further improved.

Correspondingly, the present application further provides an array substrate, which is manufactured by adopting the manufacturing method of the array substrate as mentioned above. The array substrate includes:
a substrate;
a detection circuit and at least one metal layer deviating from the detection circuit located on the substrate; and
a protective layer, the protective cover covering the metal layer and exposing the detection circuit.

Specially, referring to FIG. 3 and FIG. 4, the array substrate includes a substrate 100 (FIG 3 only shows part of a non-display area containing a packaging area A, and FIG. 4 only shows part of a non-display area containing a bonding area B) containing a display area and a non-display area. Preferably, a plurality of metal layers located in the non-display area of the substrate 100 are three layers, namely a bottom metal layer 110, an intermediate metal layer 120 and a top metal layer 130, and dielectric layers 140 which are located between the three metal layers, encircle the bottom metal layer 110 and the intermediate metal layer 120 and are located between the bottom metal layer 110 and the substrate 100 are further included; and a protective layer 150 located on the top metal layer 130 in a remaining non-display area except a detection circuit 330, an input terminal 310 and an output terminal 320 located in the bonding area B is further included.

The protective layer 150 is formed on the top metal layer 130. The protective layer 150 can protect the metal layer, damage caused to the metal layer when laser irradiation is subsequently performed on the frit in the display panel is avoided, and therefore the occurrence rate of a metal crack is lowered, and the yield of a display panel is improved easily; patterning is performed on the protective layer 150 after the protective layer 150 is formed, the detection circuit 330 and the input/output terminal 310/320 in the bonding area are exposed, electrostatic badness, caused by covering by the protective layer, of the detection circuit can be avoided, and the yield of the display panel is further improved.

Correspondingly, the present application further provides a display panel, which is manufactured by adopting the manufacturing method of the display panel as mentioned above.

To sum up, in the array substrate and the manufacturing method thereof, and the display panel and the manufacturing method thereof, after at least one metal layer is formed on the substrate, the protective layer is formed on the metal layer. The protective layer can protective the metal layer, damage caused to the metal layer when laser irradiation is subsequently performed on the frit in the display panel is avoided, and therefore the occurrence rate of the metal crack is lowered, and the yield of the display panel is improved easily. In addition, due to the technical scheme of the present application, the protective layer exposes the detection circuit, electrostatic badness, caused by covering by the protective layer, of the detection circuit can be avoided, and the yield of the display panel is further improved.

## Claims

1. An array substrate, comprising:
a substrate (10, 100);
a detection circuit (330) and at least one metal layer not overlapping with the detection circuit (330) in a direction perpendicular to the substrate (10, 100), both located on the substrate (10, 100); and
a protective layer (150) covering the metal layer,
wherein the array substrate further comprises a plurality of input and output terminals (310, 320) formed on the substrate (10, 100) and the protective layer (150) exposes the plurality of input and output terminals (310, 320), the detection circuit (330) is further arranged between the plurality of input terminals (310) and the plurality of output terminals (320) in a plane view, ,
**characterized in that**:
the detection circuit (330) and the plurality of input and output terminals (310, 320) form a bonding area for bonding a driver chip, the detection circuit (3330) contains a plurality of transistors connected with one another, connected to a display area of the substrate (10, 100) via fan-out wire, and configured for detecting a circuit of the array substrate before bonding the driver chip, and an area exposed by the protective layer (150) is equal to the bonding area or greater than the bonding area.

2. The array substrate according to claim 1, wherein a material of the protective layer (150) is one or a combination of silicon nitride, silicon oxide and silicon oxynitride.

3. The array substrate according to claim 1, wherein the substrate (10, 100) comprises a packaging area and the protective layer (150) only covers the metal layer in the packaging area.

4. A method for manufacturing an array substrate, the method comprising:
providing a substrate (10, 100), and forming a detection circuit (330) and at least one metal layer no overlapping with the detection circuit (330) in a direction perpendicular to the substrate (10, 100), the detection circuit (330) and the metal layer both located on the substrate (10, 100); and
forming a protective layer (150) to cover the metal layer,
the method further comprising: arranging a plurality of input and output terminals (310, 320) on the substrate (10, 100), the protective layer (150) exposing the plurality of input and output terminals (310, 320), and plasma dry etching a portion of the protective layer to expose the detection circuit (330), the plurality of input terminals (310) and the plurality of output terminals (320),
wherein the detection circuit (330) is further arranged between the plurality of input terminals (310) and the plurality of output terminals (320) in a plane view,
wherein the detection circuit (330) and the plurality of input and output terminals (310, 320) form a bonding area for bonding a driver chip, the detection circuit (330) contains a plurality of transistors connected with one another, connected to a display area of the substrate (10, 100) via a fan-out wire, and configured for detecting a circuit of the array substrate before bonding the driver chip, and an area exposed by the protective layer (150) is equal to the bonding area or greater than the bonding area.

5. The method for manufacturing the array substrate according to claim 4, wherein the substrate (10, 100) comprises a packaging area; and the protective layer (150) only covers the metal layer in the packaging area.

6. The method for manufacturing the array substrate according to claim 5, wherein the substrate (10, 100) further comprises a non-display area; and the packaging area, the detection circuit (330) and the plurality of input and output terminals (310, 320) are all located in the non-display area;
the metal layer is formed both in the non-display area and the display area; and while forming the metal layer, the detection circuit (330) is formed in the non-display area and a plurality of thin film transistors are formed in the display area;
the protective layer (150) is formed both in the non-display area and the display area; and
the forming a protective layer (150) further comprises: removing a portion of the protective layer (150) corresponding to a position of a contact hole in the display area to expose the contact hole while enabling the protective layer (150) to expose the detection circuit (330).

## Patentansprüche

1. Matrixsubstrat, umfassend:
ein Substrat (10, 100);
eine Erkennungsschaltung (330) und mindestens eine Metallschicht, die sich in einer Richtung senkrecht zu dem Substrat (10, 100) nicht mit der Erkennungsschaltung (330) überlappt, wobei die beiden Bauteile auf dem Substrat (10, 100) angeordnet sind; und
eine Schutzschicht (150), die die Metallschicht abdeckt,
wobei das Matrixsubstrat ferner mehrere Eingangs-und Ausgangsklemmen (310, 320) umfasst, die auf dem Substrat (10, 100) ausgebildet sind, und die Schutzschicht (150) die mehreren Eingangs-und Ausgangsklemmen (310, 320) freilegt, wobei die Erkennungsschaltung (330) in einer Draufsicht ferner zwischen den mehreren Eingangsklemmen (310) und den mehreren Ausgangsklemmen (320) angeordnet ist,
**dadurch gekennzeichnet, dass**
die Erkennungsschaltung (330) und die mehreren Eingangs-und Ausgangsklemmen (310, 320) einen Bondbereich zum Bonden eines Treiberchips bilden, wobei die Erkennungsschaltung (3330) mehrere miteinander verbundene Transistoren enthält, die über einen Fan-Out-Draht mit einem Anzeigebereich des Substrats (10, 100) verbunden sind und dazu eingerichtet sind, eine Schaltung des Matrixsubstrats vor dem Bonden des Treiberchips zu erkennen, wobei ein Bereich, der durch die Schutzschicht (150) freigelegt ist, gleich dem Bondbereich oder größer als der Bondbereich ist.

2. Matrixsubstrat nach Anspruch 1, wobei ein Material der Schutzschicht (150) eines oder eine Kombination der Materialien Siliziumnitrid, Siliziumoxid und Siliziumoxynitrid ist.

3. Matrixsubstrat nach Anspruch 1, wobei das Substrat (10, 100) einen Verpackungsbereich umfasst und die Schutzschicht (150) nur die Metallschicht in dem Verpackungsbereich abdeckt.

4. Verfahren zur Herstellung eines Matrixsubstrats, wobei das Verfahren Folgendes umfasst:
Bereitstellen eines Substrats (10, 100) und Bilden einer Erkennungsschaltung (330) und mindestens einer Metallschicht, die sich in einer Richtung senkrecht zu dem Substrat (10, 100) nicht mit der Erkennungsschaltung (330) überlappt, wobei sowohl die Erkennungsschaltung (330) als auch die Metallschicht auf dem Substrat (10, 100) angeordnet sind; und
Bilden einer Schutzschicht (150), um die Metallschicht abzudecken,
wobei das Verfahren ferner Folgendes umfasst: Anordnen mehrerer Eingangs-und Ausgangsklemmen (310, 320) auf dem Substrat (10, 100), wobei die Schutzschicht (150) die mehreren Eingangs-und Ausgangsklemmen (310, 320) freilegt, und Plasmatrockenätzen eines Abschnitts der Schutzschicht, um die Erkennungsschaltung (330), die mehreren Eingangsklemmen (310) und die mehreren Ausgangsklemmen (320) freizulegen,
wobei die Erkennungsschaltung (330) in einer Draufsicht ferner zwischen den mehreren Eingangsklemmen (310) und den mehreren Ausgangsklemmen (320) angeordnet ist,
wobei die Erkennungsschaltung (330) und die mehreren Eingangs-und Ausgangsklemmen (310, 320) einen Bondbereich zum Bonden eines Treiberchips bilden, wobei die Erkennungsschaltung (330) mehrere miteinander verbundene Transistoren enthält, die über einen Fan-Out-Draht mit einem Anzeigebereich des Substrats (10, 100) verbunden sind und dazu eingerichtet sind, eine Schaltung des Matrixsubstrats vor dem Bonden des Treiberchips zu erkennen, wobei ein Bereich, der durch die Schutzschicht (150) freigelegt ist, gleich dem Bondbereich oder größer als der Bondbereich ist.

5. Verfahren zur Herstellung des Matrixsubstrats nach Anspruch 4, wobei das Substrat (10, 100) einen Verpackungsbereich umfasst und die Schutzschicht (150) nur die Metallschicht in dem Verpackungsbereich abdeckt.

6. Verfahren zur Herstellung des Matrixsubstrats nach Anspruch 5, wobei das Substrat (10, 100) ferner einen Nicht-Anzeigebereich umfasst; wobei der Verpackungsbereich, die Erkennungsschaltung (330) und die mehreren Eingangs-und Ausgangsklemmen (310, 320) alle in dem Nicht-Anzeigebereich angeordnet sind;
wobei die Metallschicht sowohl in dem Nicht-Anzeigebereich als auch in dem Anzeigebereich ausgebildet ist; und wobei während der Ausbildung der Metallschicht die Erkennungsschaltung (330) in dem Nicht-Anzeigebereich ausgebildet ist und mehrere Dünnfilmtransistoren in dem Anzeigebereich ausgebildet sind;
wobei die Schutzschicht (150) sowohl in dem Nicht-Anzeigebereich als auch in dem Anzeigebereich ausgebildet ist; und
wobei das Bilden einer Schutzschicht (150) ferner Folgendes umfasst: Entfernen eines Abschnitts der Schutzschicht (150), der einer Position eines Kontaktlochs in dem Anzeigebereich entspricht, um das Kontaktloch freizulegen, während es der Schutzschicht (150) ermöglicht wird, die Erkennungsschaltung (330) freizulegen.

## Revendications

1. Substrat de matrice, comprenant :
un substrat (10, 100) ;
un circuit de détection (330) et au moins une couche métallique ne chevauchant pas le circuit de détection (330) dans une direction perpendiculaire au substrat (10, 100), tous deux situés sur le substrat (10, 100) ; et
une couche de protection (150) recouvrant la couche métallique,
dans lequel, le substrat de matrice comprend en outre une pluralité de bornes d'entrée et de sortie (310, 320) formées sur le substrat (10, 100) et la couche de protection (150) expose la pluralité de bornes d'entrée et de sortie (310, 320), le circuit de détection (330) est disposé en outre entre la pluralité de bornes d'entrée (310) et la pluralité de bornes de sortie (320) dans une vue plane,
**caractérisé en ce que** :
le circuit de détection (330) et la pluralité de bornes d'entrée et de sortie (310, 320) forment une zone de liaison pour lier une puce d'entraînement, le circuit de détection (3330) comporte une pluralité de transistors connectés les uns aux autres, connectés à une zone d'affichage du substrat (10, 100) par l'intermédiaire d'un fil de sortance, et configurés pour détecter un circuit du substrat de matrice avant de lier la puce d'entraînement, et une surface exposée par la couche de protection (150) est égale ou supérieure à la surface de liaison.

2. Substrat de matrice selon la revendication 1, dans lequel un matériau de la couche de protection (150) est un parmi le nitrure de silicium, l'oxyde de silicium et l'oxynitrure de silicium ou leurs combinaisons.

3. Substrat de matrice selon la revendication 1, dans lequel le substrat (10, 100) comprend une zone d'emballage et la couche de protection (150) ne recouvre que la couche métallique dans la zone d'emballage.

4. Procédé de fabriquer un substrat de matrice, le procédé comprenant :
fournir un substrat (10, 100), et former un circuit de détection (330) et au moins une couche métallique ne chevauchant pas le circuit de détection (330) dans une direction perpendiculaire au substrat (10, 100), le circuit de détection (330) et la couche métallique étant tous situés sur le substrat (10, 100) ; et
former une couche de protection (150) pour recouvrir la couche métallique,
le procédé comprenant en outre : disposer une pluralité de bornes d'entrée et de sortie (310, 320) sur le substrat (10, 100), la couche de protection (150) exposant la pluralité de bornes d'entrée et de sortie (310, 320), et effectuer une gravure à sec par plasma sur une partie de la couche de protection pour exposer le circuit de détection (330), la pluralité des bornes d'entrée (310) et la pluralité des bornes de sortie (320),
dans lequel le circuit de détection (330) est disposé en outre entre la pluralité de bornes d'entrée (310) et la pluralité de bornes de sortie (320) dans une vue plane,
dans lequel le circuit de détection (330) et la pluralité de bornes d'entrée et de sortie (310, 320) forment une zone de liaison pour lier une puce d'entraînement, le circuit de détection (330) comporte une pluralité de transistors connectés les uns aux autres, connectés à une zone d'affichage du substrat (10, 100) par l'intermédiaire d'un fil de sortance, et configurés pour détecter un circuit du substrat de matrice avant de lier la puce d'entraînement, et une surface exposée par la couche de protection (150) est égale ou supérieure à la surface de liaison.

5. Procédé de fabriquer le substrat de matrice selon la revendication 4, dans lequel le substrat (10, 100) comprend une zone d'emballage ; et la couche de protection (150) ne recouvre que la couche métallique dans la zone d'emballage.

6. Procédé de fabriquer le substrat de matrice selon la revendication 5, dans lequel le substrat (10, 100) comprend en outre une zone non-affichage ; et la zone d'emballage, le circuit de détection (330) et la pluralité des bornes d'entrée et de sortie (310, 320) sont tous situés dans la zone non-affichage ;
la couche métallique est formée d'une part dans la zone non-affichage et d'autre part dans la zone d'affichage ; et lors de la formation de la couche métallique, le circuit de détection (330) est formé dans la zone non-affichage et une pluralité de transistors à couche mince est formée dans la zone d'affichage ;
la couche de protection (150) est formée d'une part dans la zone non-affichage et d'autre part dans la zone d'affichage ; et
la formation d'une couche de protection (150) comprend en outre : éliminer une partie de la couche de protection (150) correspondant à une position d'un trou de contact dans la zone d'affichage pour exposer le trou de contact tout en permettant à la couche de protection (150) d'exposer le circuit de détection (330).
